(19) Europäisches Patentamt
European Patent Office
Office européen des brevets

(11) EP 4 253 934 A1

# (12) EUROPEAN PATENT APPLICATION

(43) Date of publication:
**04.10.2023 Bulletin 2023/40**

(21) Application number: **22165535.0**

(22) Date of filing: **30.03.2022**

(51) International Patent Classification (IPC):
***G01M 13/045*** *(2019.01)*

(52) Cooperative Patent Classification (CPC):
**G01M 13/045**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Aktiengesellschaft**
**80333 München (DE)**

(72) Inventor: **NAIR, P. V. Sudev**
**560078 Bangalore, Karnataka (IN)**

(74) Representative: **Isarpatent**
**Patent- und Rechtsanwälte Barth**
**Charles Hassa Peckmann & Partner mbB**
**Friedrichstrasse 31**
**80801 München (DE)**

## (54) SYSTEM, APPARATUS AND METHOD FOR MISALIGNMENT-BASED REMAINING USEFUL LIFE ESTIMATION OF A BEARING

(57) Disclosed herein is a system and method for estimating remaining useful life of a bearing associated with an electric machine (105). The electric machine (105) is configured to transfer rotational energy to a load via a shaft (107) supported by the bearing. The method comprises obtaining operational data associated with the electric machine (105) in real-time from one or more sources. Further, the operational data is analysed to detect a misalignment of the shaft (107) of the electric machine (105). Upon detecting the misalignment, using a virtual model of at least the electric machine (105) to simulate a real-time behaviour of at least the electric machine (105) is simulated to achieve a simulation result indicative of a misalignment value corresponding to the misalignment of the shaft (107). Further, a remaining useful life of the bearing is predicted based on the misalignment value.

FIG 1A

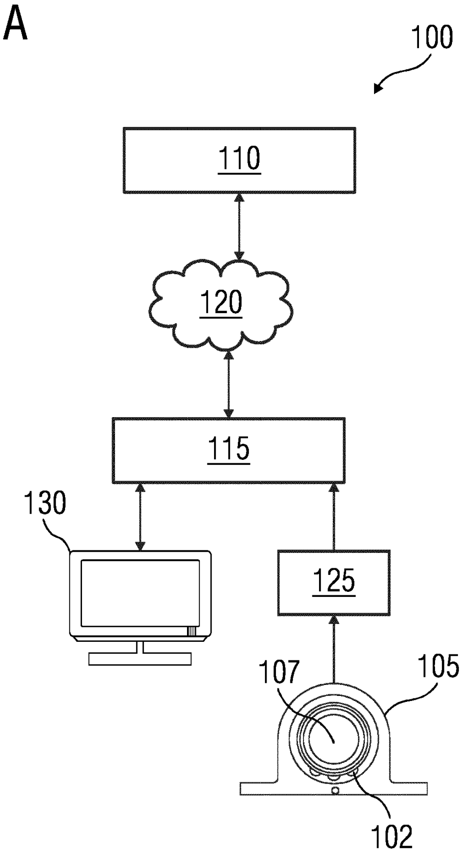


EP 4 253 934 A1

## Description

The present invention relates to estimation of remaining useful life, and more particularly relates to a system and method for estimating remaining useful life of bearings.

Typically, large electric motors are directly coupled to respective loads with rigid or flexible couplings. Rigid couplings do not compensate for misalignments between the motor and driven equipment (i.e., the load). Flexible couplings can tolerate misalignment to an extent. Flexible couplings may also reduce vibration transmitted from the motor to the load and vice versa. Further, some flexible couplings may also insulate shaft of the driven equipment against stray electrical currents.

Although flexible couplings reduce vibration impact to an extent, dynamic force resulting from misalignment of the motor and the driven equipment may severely impact the drive-end bearing of the motor. The severity of the impact on the drive-end bearing may also vary based on whether the misalignment is parallel or angular in nature. The misalignment may occur due to thermal expansion of the coupler or due to errors in pre-aligning the motor and the driven equipment prior to operation.

Existing art does not allow for detection and estimation of severity of misalignment during operational phase of the motor and the driven equipment. Typically, such misalignments are detected and a severity of misalignment is estimated during a maintenance phase, thereby leading to additional downtime. Further, unnoticed misalignment severely impacts the remaining useful life of the bearing, thereby ultimately impacting operation of the motor. In light of the above, there exists a need for online estimation of severity of misalignment, and for determining a remaining useful life of a drive-end bearing based on the estimated misalignment.

In light of the above, there exists a need for real-time estimation of remaining useful life of a bearing based on misalignment.

Therefore, it is an object of the present invention to provide a system, apparatus and method for misalignment-based remaining useful life estimation of a bearing of an electric machine.

The object of the present invention is achieved by a method of estimating remaining useful life of a bearing of an electric machine as disclosed herein. The electric machine operable to transfer rotational energy to a load via a shaft supported by the bearing. The method comprises obtaining operational data associated with the electric machine and indicative of the misalignment of the shaft, in real-time from one or more sources.

Advantageously, the present invention facilitates estimation of remaining useful life of the bearing in real-time during operation of the electric machine, i.e. via online monitoring.

The method further comprises analysing the operational data to detect a misalignment of the shaft of the electric machine. In an embodiment, detecting misalignment of the shaft of the electric machine based on the operational data comprises computing a characteristic signature of the electric machine based on the operational data. In an embodiment, the characteristic signature is at least one of a current signature, a vibration signature and a thermal signature. In a further embodiment, the characteristic signature is generated from the operational data using one or more transform functions. In an alternate embodiment, the characteristic signature is generated based on the operational data using a regression model. Further, the characteristic signature is analysed to detect misalignment of the shaft.

Advantageously, the regression models provide an alternative way of sensorless measurement of operational parameters and eliminate the need for multiple sensors for measurement of a plurality of operational parameters.

The method further comprises upon detecting the misalignment, using a virtual model of at least the electric machine to simulate a real-time behaviour of at least the electric machine, to achieve a simulation result indicative of a misalignment value corresponding to the misalignment of the shaft. In an embodiment, using the virtual model of at least the electric machine to simulate the real-time behaviour of at least the electric machine, to achieve the simulation result indicative of a misalignment value corresponding to the misalignment of the shaft comprises, dynamically updating the virtual model of the electric machine based on the operational data upon detecting the misalignment. Further, a machine-executable simulation instance of at least the electric machine is configured based on the updated virtual model. Furthermore, the configured simulation instance is executed in a simulation environment to generate the simulation result.

Advantageously, the misalignment value is determined via simulations based on a virtual model. As a result, manual intervention may be eliminated in estimating misalignment. Further, the present invention helps in quantifying misalignment during operation of the electric machine, in contrast the existing art that only helps in detecting an outcome of misalignment.

The method further comprises predicting a remaining useful life of the bearing based on the misalignment value. In an embodiment, predicting the remaining useful life of the bearing based on the misalignment value comprises, computing a dynamic misalignment force on the bearing in real-time based on the misalignment value using a predetermined misalignment force model. Further, a rating life model of the bearing is dynamically configured based on the computed dynamic misalignment force. The remaining useful life of the bearing is further predicted using the configured rating life model. The method further comprises generating a notification indicating the predicted remaining useful life of the bearing on an output device.

Advantageously, the present invention helps in continuously determining effect of misalignment on remaining useful life of a bearing through real-time monitoring of operational parameters such as current signature or vibration signature, and the simulation results.

In an embodiment, the method further comprises using the predicted remaining useful life of the bearing to adjust at least one control parameter of the electric machine. In an embodiment, the at least one control parameter is adjusted to modify at least one of a speed and load of the electric machine.

Disclosed herein is also an apparatus for estimating remaining useful life of a bearing, in accordance with an embodiment of the present invention. The apparatus comprises one or more processing units, and a memory unit operatively coupled to the one or more processing units. The memory unit comprises a bearing monitoring module stored in the form of machine-readable instructions executable by the one or more processing units. The bearing monitoring module is configured to perform method steps described above.

Disclosed herein is also a system for estimating remaining useful life of a bearing, in accordance with an embodiment of the present invention. The system comprises one or more sources capable of providing operational data associated with a bearing and an apparatus as described above, communicatively coupled to the one or more sources. The term 'sources' as used herein, refer to electronic devices configured to obtain and transmit the operational data to the apparatus. Non-limiting examples of sources include sensing units, controllers and edge devices.

The object of the present invention is also achieved by a computer-readable medium, on which program code sections of a computer program are saved, the program code sections being loadable into and/or executable by a processor which performs the method as described above when the program code sections are executed.

The realization of the invention by a computer program product and/or a non-transitory computer-readable storage medium has the advantage that computer systems can be easily adopted by installing computer program in order to work as proposed by the present invention.

The computer program product can be, for example, a computer program or comprise another element apart from the computer program. This other element can be hardware, for example a memory device, on which the computer program is stored, a hardware key for using the computer program and the like, and/or software, for example a documentation or a software key for using the computer program.

Disclosed herein is also a computer-program having machine-readable instructions, which when executed by one or more computing devices, cause the one or more computing devices to perform a method according to the above-described method steps. A machine-readable storage medium comprising a computer-program as described above is also disclosed.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:

FIG 1A illustrates a block diagram of a system for estimating remaining useful life of a bearing associated with an electric machine 105, in accordance with an embodiment of the present invention;

FIG 1B illustrates a block diagram of an apparatus for estimating remaining useful life of a bearing associated with an electric machine 105, in accordance with an embodiment of the present invention;

FIG 2 illustrates the structure of a ball bearing;

FIG 3A illustrates a motor coupled to a pump;

FIG 3B illustrates a test setup for generating experimental data associated with the motor, in accordance with an embodiment of the present invention;

FIG 4 shows a flowchart of a method for estimating RUL of the bearing, in accordance with an embodiment of the present invention;

FIG 5 shows a Graphical User Interface 500 displaying an example of a current spectrum generated based on current signature of a motor;

FIG 6 shows a workflow for estimating RUL of a drive-end bearing of a motor, in accordance with an exemplary embodiment of the present invention; and

FIG 7 illustrates a workflow for estimating RUL of a driveend bearing of a motor, in accordance with another exemplary embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

FIG 1A illustrates a block diagram of a system 100 for estimating remaining useful life (RUL) of a bearing 102 associated with an electric machine 105, in accordance with an embodiment of the present invention. Non-limiting examples of an electric machine may include AC generators, DC generators, AC motors, DC motors, permanent magnet machines, induction machines and brushed machines. The electric machine 105 is mechanically coupled to a load i.e., the driven equipment via a coupler (not shown). More specifically, the coupler mechanically couples a shaft 107 of the electric machine 105 to the load to enable transfer of rotational energy.

The bearing 102 is a mechanical component adapted to support an applied load on the shaft 107 of the electric machine 105, and allows rotational motion of the shaft within a supporting structure. Non-limiting examples of bearings include deep groove ball bearings, cylindrical roller bearings, tapered roller bearings, thrust bearings, angular contact ball bearings, needle ball bearings and the like. The system 100 is configured to estimate the RUL of the bearing 102 based on misalignment of the shaft.

In an embodiment, the bearing 102 comprises an inner race, an outer race and a plurality of rolling elements disposed in a gap between the inner race and the outer race. The bearing 102 further comprises a cage positioned between the inner race and the outer race for maintaining a symmetric radial gap between the rolling elements. An example of a bearing 102 is described later in the present disclosure with reference to FIG 2.

The system 100 comprises an apparatus 110 communicatively coupled to one or more edge devices 115, via a network 120. The network 120 may include, for example, local area network (LAN), wide area network (WAN), Wi-Fi, etc. The edge device 115 is configured to receive operational data from at least one sensing unit 125 associated with the electric machine 105.

The sensing unit 125 generates an output signal indicative of an operational parameter associated with the electric machine 105 in real-time. In a preferred embodiment, the sensing unit 125 may include a current transformer, configured to output an electrical signal corresponding to a current signature associated with the electric machine 105. The current signature includes a time-series current signal. In another embodiment, the sensing unit 125 may include a vibration sensor configured to generate an electrical signal corresponding to vibration signature of the electric machine 105. The vibration signature may include a time-domain acceleration signal or a velocity signal. In yet another embodiment, the sensing unit 125 may include a temperature sensor configured to generate an electrical signal corresponding to a thermal signature associated with the electric machine 105. The thermal signature may include a time-domain temperature signal.

The sensing unit 125 is further communicatively coupled to the apparatus 110. In an embodiment, the operational data are obtained through data acquisition interfaces associated with the edge device 115. The edge device 115 provides the operational data in real-time to the apparatus 110. In addition, the edge device 115 is also configured to provide one or more bearing parameters associated with the bearing 102 to the apparatus 110. The one or more bearing parameters may be stored in a memory of the edge device 115 or may be input to the edge device 115 by an operator. For example, the edge device 115 may be communicatively coupled to a client device 130. Non-limiting examples of client devices include, personal computers, workstations, personal digital assistants, human machine interfaces. The client device 130 may enable the operator to input values for the one or more bearing parameters through a web-based interface. Upon receiving the one or more bearing parameters from the operator, the edge device 115 transmits a request for estimating a RUL of the bearing 102 to the apparatus 110.

The one or more bearing parameters include, but are not limited to, a standard bearing number, a ball size, bearing static load, density of material, angular velocity, internal clearance, bearing diameter, number of rolling elements, radius of rolling element, diameter of inner race, diameter of outer race, fatigue load limit, and type of lubricant used in the bearing 102. It must be understood that the standard bearing number is indicative of certain specifications such as a ball size, bearing static load, density of material, internal clearance, bearing diameter, number of rolling elements, radius of rolling element, diameter of inner race, diameter of outer race, fatigue load limit, bearing width and the like, as provided by a manufacturer of the bearing 102. Therefore, in an embodiment, the standard bearing number associated with the bearing 102 may be provided in place of explicitly providing the above-mentioned bearing parameters.

The RUL of the bearing 102 may be affected by defects due to initiation of a failure mode in the bearing 102. Non-limiting examples of failure modes include spalling, pitting, plastic deformation, abrasion, electrical erosion and corrosion typically on an outer race of the bearing 102. Some of the defects may occur due to misalignment of the shaft, eccentricity of the shaft, loose foot, presence of contaminants or due to properties of a lubricant used within the bearing 102.

In the present embodiment, the apparatus 110 is deployed in a cloud computing environment. As used herein, "cloud computing environment" refers to a processing environment comprising configurable computing physical and logical resources, for example, networks, servers, storage, applications, services, etc., and data distributed over the network 120, for example, the internet. The cloud computing environment provides on-demand network access to a shared pool of the configurable computing physical and logical resources. The apparatus 110 includes a bearing monitoring module that estimates RUL of a given bearing based on the corresponding operational data. Hereinafter, the term 'operational data' may be understood to comprise output of the at least one sensing unit 125, bearing parameters as well as specifications of the load. Additionally, the apparatus 110 may include a network interface for communicating with the edge device 115 via the network 120.

The apparatus 110 comprises a processing unit 135, a memory unit 140, a storage unit 145, a communication unit 150, the network interface 155 and a standard interface or bus 160, as shown in FIG 1B. The apparatus 110 can be a computer, a workstation, a virtual machine running on host hardware, a microcontroller, or an integrated circuit. As an alternative, the apparatus 110 can be a real or a virtual group of computers (the technical term for a real group of computers is "cluster", the technical term for a virtual group of computers is "cloud").

The term 'processing unit' 135, as used herein, means any type of computational circuit, such as, but not limited to, a microprocessor, microcontroller, complex instruction set computing microprocessor, reduced instruction set computing microprocessor, very long instruction word microprocessor, explicitly parallel instruction computing microprocessor, graphics processor, digital signal processor, or any other type of processing circuit. The processing unit 135 may also include embedded controllers, such as generic or programmable logic devices or arrays, application specific integrated circuits, single-chip computers, and the like. In general, a processing unit 135 may comprise hardware elements and software elements. The processing unit 135 can be configured for multithreading, i.e., the processing unit 135 may host different calculation processes at the same time, executing the either in parallel or switching between active and passive calculation processes.

The memory unit 140 may be volatile memory and non-volatile memory. The memory unit 140 may be coupled for communication with the processing unit 135. The processing unit 135 may execute instructions and/or code stored in the memory unit 140. A variety of computer-readable storage media may be stored in and accessed from the memory unit 140. The memory unit 140 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

The memory unit 140 comprises a bearing monitoring module 165 in the form of machine-readable instructions on any of the above-mentioned storage media and may be in communication to and executed by the processing unit 135. The bearing monitoring module 165 comprises a preprocessing module 170, an analysis module 175, a simulation module 180, a life estimation module 185 and a notification module 190. The preprocessing module 170 is configured for obtaining operational data associated with the electric machine 105 in real-time from one or more sources. The sources include the edge device 115, the one or more sensing units 125 and the client device 130. The analysis module 175 is configured for analysing the operational data to detect a misalignment of the shaft of the electric machine 105. The simulation module 180 is configured for simulating a real-time behaviour of at least the electric machine 105 based on a virtual model to generate a simulation result, upon detecting the misalignment. The life estimation module 185 is configured for predicting the RUL of the bearing 102 based on the misalignment value. The notification module 190 is configured for generating a notification indicating the predicted RUL of the bearing 102 on an output device. In the present embodiment, the output device may be the client device 130.

The storage unit 145 comprises a non-volatile memory which stores default bearing parameters associated with standard bearing numbers. The storage unit 145 includes a database 195 that comprises default values of bearing parameters, look up tables for control parameters corresponding to different applications, predefined mathematical models corresponding to different types bearings, and one or more look-up tables comprising predetermined values for factors that vary with operating conditions of the bearing 102. The bus 160 acts as interconnect between the processing unit 135, the memory unit 140, the storage unit, and the network interface 155. The communication unit 150 enables the apparatus 110 to receive requests from the edge device 115. The communication module may support different standard communication protocols such as Transport Control Protocol/Internet Protocol (TCP/IP), Profinet, Profibus, and Internet Protocol Version (IPv).

Those of ordinary skilled in the art will appreciate that the hardware depicted in FIG 1A and 1B may vary for different implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter, network connectivity devices also may be used in addition or in place of the hardware depicted. The depicted example is provided for the purpose of explanation only and is not meant to imply architectural limitations with respect to the present disclosure.

Hereinafter, the invention is explained in detail by considering a coupled system, wherein the electric machine 105 is a motor and the load is a pump, for ease of explanation. The bearing is, for example, a ball bearing mounted on the shaft of the motor.

FIG 2 illustrates the structure of a ball bearing 200. The ball bearing 200 comprises an outer race 210 of diameter D, a plurality of balls 215 each of radius $r_{ball}$, a cage 220 and an inner race 225 of diameter d. The plurality of balls 215 are disposed in a gap between the outer race 210 and the inner race 225. The cage 220 maintains a symmetric radial spacing between the balls 215. $\alpha$ is the angle of contact between the ball and the outer race. Here, dm is the pitch diameter of the bearing 200.

FIG 3A and FIG 3B illustrate a test-set up 300 for generating experimental data associated with a motor 305, in accordance with an embodiment of the present invention. The experimental data is used to build a virtual model of the motor 305.

The virtual model may be based on one or more of physics-based models, Computer-Aided Design (CAD) models, Computer-Aided Engineering (CAE) models, one-dimensional (1D) models, two-dimensional (2D) models, three-dimensional (3D) models, finite-element (FE) models, descriptive models, metamodels, stochastic models, parametric models, reduced-order models, statistical models, heuristic models, prediction models, ageing models, machine learning models, Artificial Intelligence models, deep learning models, system models, surrogate models and the like.

The motor 305 is coupled to a pump 310 via a coupler 315, to form a coupled system, as shown in FIG 3A. Hereinafter, a shaft 320 of the motor 305 is interchangeably called the driving shaft 320 or simply 'the shaft 320' and a shaft 325 of the pump 310 is explicitly referred to as the driven shaft 325. The driving shaft 320 is mounted inside a casing 330 of the motor 305 using a suitable support structure as indicated in FIG 3B. Further, a drive-end bearing 335 is disposed between the supporting structure and the driving shaft 320 to guide the movement of the driving shaft 320 and to prevent oscillations upon application of load (i.e. upon coupling of the driven shaft 325) to the driving shaft 320.

The test set-up 300 comprises one or more current transformers 340 mounted on the casing 330 of the motor 305. The current transformer 340 is configured to generate a current signature associated with the motor 305. The set-up further comprises one or more vibration sensors 345 mounted on the driving shaft 320 to measure a vibration signal associated with the coupler 315. The outputs from the one or more current transformers 340 and the one or more vibration sensors 345 are further provided to an apparatus 350 (similar to apparatus 110) as experimental data, as illustrated in FIG 3B. The apparatus 350 may further execute one or more machine-readable instructions to build the virtual model as explained in detail below.

In an embodiment, the virtual model may include any virtual representation that serves as a real-time digital counterpart of the coupled system, for example, a digital twin. In the present embodiment, the virtual model is built based on the current signature and vibration signature. Similarly, other operational parameters like thermal signature may also be used to build the virtual model. In the present embodiment, the virtual model comprises one or more regression models that relate at least one operational parameter of the motor 305 to one or more other operational parameters of the motor 305.

In order to build the virtual model, firstly, experimental data associated with current signature, vibration signature and thermal signature may be generated, for a set of predefined operating conditions of the motor 305. In the present embodiment, the predefined operation conditions include at least one of a predefined load and misalignment value. For example, the predefined operating conditions may include combinations of loads (e.g., 50%, 60%, 70%, 90%, 95% etc., of full load capacity) and misalignment values (e.g., 0.1 mm, 0.2 mm, 0.3 mm, 0.4 mm etc.). Further, the misalignment may be one of angular misalignment, radial misalignment or parallel misalignment. More specifically, the misalignment is artificially introduced into the motor 305 by displacing the driving shaft 320 by a value equal to the specific misalignment value and/or angle of alignment. The experimental data thus generated is further used to build the virtual model of the coupled system. The virtual model may be further calibrated based on a test dataset. The virtual model thus built is adapted to predict misalignment value based on a given set of operating conditions.

It may be understood by a person skilled in the art that the misalignment in the coupler 315 is dependent on stiffness of the coupler 315. In order to improve the speed of simulation, a reduced order model of the coupler 315 may be used. For example, the coupler 315 may be modelled as a pseudo-bearing. An equivalent radial stiffness of the pseudo-bearing may be predetermined using a finite-element analysis (FEA) technique. For example, the coupler 315 may be modelled as pseudo-bearing of a specific overall stiffness, and the equivalent radial stiffness of the pseudo-bearing may be estimated using two-dimensional (2D) FEA and/or three-dimensional (3D) FEA. In another embodiment, the model of the pseudo-bearing may be configured based on manufacturer-supplied specifications associated with the coupler 315. Non-limiting examples of manufacturer-supplied specifications include weight, torsional stiffness, inertia, maximum bore, axial deflection, angular deflection etc.

The experimental data may also be used to build regression models that relate at least one operating parameter to at least another operating parameter of the motor 305. Regression algorithm is a type of supervised learning in Machine Learning (ML) that helps in mapping a predictive relationship between dependent and independent variables. The regression algorithms may be one of a linear regression and non-linear regression.

The linear regression algorithm generates a machine learning model (henceforth called the linear regression model) that assumes a linear relationship between the dependent variable and the independent variable. Non-limiting examples of linear regression algorithms include, ridge regression, neural network regression & lasso regression. On the other hand, the non-linear regression algorithm generates a machine learning model (non-linear regression model) that relates dependent and independent variables using non-linear relationships. Non-linear regression models may be based on, for example, logarithmic functions, trigonometric functions, exponential functions, power functions, Lorenz curves, Gaussian functions etc. It must be understood by a person having ordinary skill in the art that non-linear regression models are developed through a series of iterative approximations based on methods such as Gauss-Newton method, the Levenberg-Marquardt method etc. It must also be understood that non-linear regression models may be approximated to linear regression models using standard techniques known to a person skilled in the art.

In linear regression, the linear regression model is iteratively trained until a loss function is minimized. The loss function is calculated as below:

$$\text{Loss function: (simulated output} - \text{actual output)}^2 \qquad (1)$$

where 'simulated output' is the output predicted by the linear regression model for a given set of conditions, and the 'actual output' generated by the one or more sensing units for the same set of conditions.

In non-linear regression, the non-linear regression model is generated based on a 'sum of squares' function. The Sum of Squares (SS) function is used to identify a relationship that best fits a given set of experimental data. More specifically, the best fitting relationship minimizes the SS function for a given regression model. For a set *X* of n items:

$$Sum\ of\ Squares = \sum_{i=0}^{n} (X_i - \overline{X})^2 \qquad (2)$$

where, $X_i$ is the $i_{th}$ item in the set;

$\overline{X}$ is the mean of all items in the set; and

$(X_i - \overline{X})$ is the deviation of each item from the mean.

The regression models thus generated are further calibrated based on test data comprising actual outputs generated by the sensing units 340 and 345. In other words, the regression models are calibrated to further reduce deviations between simulated outputs of the regression model and the actual outputs.

In a preferred embodiment, at least one regression model that relates current signature to vibration signature of the motor 305 is generated based on the experimental data. In an example, example, at least one advanced signal processing technique may be used to extract features from each of the vibration signature and current signature measured using the sensing units 340 and 345. Non-limiting examples of extracted features include, RMS, Kurtosis, crest factor and peak value. Non-limiting examples of advanced signal processing techniques include, but are not limited to, Fast Fourier Transform, Continuous Wavelet Transform, Discrete Wavelet Transform and Spectral Kurtosis. Further, the respective extracted features of the current signature and the vibration signature for same set of the operating conditions are used to generate the regression models as described above. Similarly, a second regression model that relates current signature to thermal signature, a third regression model that relates vibration signature to thermal signature etc., may be generated.

It must be understood that regression models may be generated and calibrated in a similar fashion as described above, using linear or non-linear regressions, for any set of operating parameters associated with the motor 305. The regression models thus generated are used along with the virtual model of the coupled system to simulate, in a simulation environment, a behaviour of the motor 305 or the coupled system during operation.

FIG 4 shows a flowchart of a method 400 for estimating RUL of the bearing 102, in accordance with an embodiment of the present invention. The method comprises steps 405 through 420.

The method 400 is explained in conjunction with FIGS 1A & 1B, with reference to a motor coupled to a pump.

At step 405, operational data associated with the electric machine 105 and indicative of the misalignment of the shaft 107, is obtained from one or more sources associated with the electric machine 105 in real-time. It must be understood that the term "real-time" as used herein corresponds to the operational phase of the electric machine 105. The sources include the edge device 115, the one or more sensing units 125 and the client device 130. The electric machine 105 is configured to transfer rotational energy to a load via a shaft supported by the bearing 102. In case of the motor, the shaft of the motor is coupled to a pump via a coupler, to enable transfer of rotational energy from the motor to the pump. The operational data includes at least one of current data, vibration data and thermal data corresponding to the motor.

At step 410, the operational data is analysed to detect a misalignment of the shaft of the electric machine 105. In an embodiment, a characteristic signature of the electric machine 105 is computed based on the operational data. The real-time operational data may be represented in time-series format or may be transformed into other domains using transform functions such as Continuous Wavelet Transform, Discrete Wavelet Transform or Fast Fourier Transform. In the present example, the operational data associated with the motor may include at least one of current data, vibration data and thermal data. Correspondingly, the characteristic signatures may include current signatures, vibration signatures, thermal signatures etc. It must be understood that characteristic signatures may include representation of the operational data in time domain or frequency domain. As a result, the characteristic signatures may also include frequency spectrums such as current spectrum, vibration spectrum and thermal radiation spectrum.

In an embodiment, one or more characteristic signatures are indirectly derived from the operational data using regression models. For example, the first regression model as explained with reference to FIG 3, may be used to determine at least one feature corresponding to a vibration signature of the motor based on current signature obtained from the one or more sensing units 125. In an embodiment, the first regression model may generate a set of data points over a predefined interval that form the vibration signature associated with the motor, from data points in the current signature.

The computed characteristic signature is analysed to detect misalignment of the shaft 107. In the present example, the misalignment may be induced by non-alignment of the driving shaft 107 of the motor and a driven shaft of the pump. The presence of misalignment is further detected by firstly generating a vibration spectrum of the motor. The vibration spectrum is generated by applying Fast Fourier transform to a time-series vibration signal obtained from the one or more sensing units 125. Further, the misalignment is detected based on presence of peaks, e.g. 2X and 3X peaks, in the vibration spectrum. Similarly, peaks of a current spectrum of the motor, generated based by applying transform functions to a current signal obtained from the one or more sensing units 125, may also be analysed to detect misalignment.

At step 415, a virtual model of at least the electric machine 105 is used to simulate a real-time behaviour of at least the electric machine 105, to achieve a simulation result indicative of a misalignment value corresponding to the misalignment of the shaft 107, upon detecting the misalignment. The simulation result is indicative of a misalignment value corresponding to the misalignment of the shaft 107. More specifically, the simulated misalignment value corresponds to the actual misalignment value of the shaft 107, as the virtual model is configured to simulate real-time behaviour of the motor 105. The misalignment value may be defined as a radial distance between at least one reference point on the shaft 107 and at least one point on a casing of the motor, measured radially. For example, the reference points may be positioned at two extreme ends of the shaft 107, inside a casing of the motor. In case of parallel misalignment, the misalignment value is not equal to zero, but constant over time. In case of angular misalignment, the misalignment value varies over time. For example, the misalignment values may be 0.1 mm, 0.15 mm, 0.23 mm, 0.19 mm etc.

In a preferred embodiment, the virtual model is a digital twin of the coupled system running on the edge device 115. In an embodiment, estimating the misalignment value based on the virtual model comprises dynamically updating the virtual model of at least the electric machine 105 based on the operational data obtained in real-time. Here, the operational data may also include bearing parameters provided by the edge device 115 as well as specifications of the load applied by the pump on the shaft 107. Further, a machine-executable simulation instance of at least the electric machine is configured based on the updated virtual model. The simulation instance is further executed in a simulation environment to generate simulation results. The simulation results are indicative of a misalignment value of the coupler in real-time. The misalignment value is a numerical value indicative of a severity of misalignment at the coupler. The misalignment value may indicate radial misalignment, angular misalignment or parallel misalignment between the driving shaft 107 and the driven shaft.

At step 420, a RUL of the bearing 102 is predicted based on the misalignment value. In an example, the RUL may be expressed as number of revolutions before the failure occurs. In another example, the RUL is expressed as number of operating hours at a constant speed before the failure. In a preferred embodiment, a rating life model as shown in equation (3) is dynamically configured based on the dynamic misalignment force:

$$L_{10} = a_1 a_{iso} \left(\frac{C}{P}\right)^3 \qquad (3)$$

where, $a_{iso}$ is a life modification factor based on systems approach for life calculation given by:

$$a_{iso} = f\left(\frac{e_c C_u}{P}, K\right) \quad (4)$$

where, $a_1$ is a life modification factor for reliability, $C_u$ is fatigue load limit in Newtons, $e_c$ is a contamination factor specific to the defect size, P is dynamic equivalent radial load in Newtons, $C$ is dynamic equivalent radial load rating, K is viscosity ratio. Here, the dynamic parameter used for configuring the rating life model is the dynamic equivalent radial load P or the dynamic misalignment force. The dynamic misalignment force corresponding to the misalignment value is computed using a misalignment force model. The misalignment force model is a predetermined mathematical model that relates misalignment value to the dynamic misalignment force. In an exemplary embodiment, the misalignment force model may resolve force and moment components along X, Y and Z axes at the coupler based on the simulated misalignment value.

The life modification factor for reliability is a predefined value specified in ISO 281:2007 for a given value of reliability. For example, if the reliability may be considered to be 90%, a1 is taken as 1. The value of reliability is taken as 90% by default. In an embodiment of the present disclosure, the value of reliability may be modified by an operator through the client device. The life modification factor for reliability may be further obtained from a first lookup table stored in the database 195, based on the value of reliability. The fatigue load limit and the dynamic equivalent radial load rating are obtained from the one or more bearing parameters associated with the bearing 102.

At step 425, a notification indicating the RUL may also be generated on an output device. For example, a text notification indicating the RUL of the bearing 102 along with the misalignment value may be generated on the user interface in real-time. The notification may also include an indication of a maintenance schedule for the electric machine 105 based on the RUL of the bearing 102. For example, if the RUL of the bearing 102 reduces below 100 hours, the notification may indicate that the electric machine 105 should be serviced within a specified time, say 3 days, to avoid breakdowns.

The user interface may be configured to receive, in response to the notification, an input for choosing an option to optimize the performance of the bearing 102. For example, the user interface may display a notification "Would you like to optimize the performance of your 6203 Bearing"?, along with two tabs "Yes" and "No". The user may select the tab "Yes" on the user interface using an input means to choose optimized bearing performance. Otherwise, the user may select the tab "No" if optimized bearing performance is not desired.

In an embodiment, the predicted RUL of the bearing 102 is used to adjust at least one control parameter of the electric machine 105, such that the RUL is optimized. The control parameter may be adjusted to modify a speed or load of the electric machine 105. For example, the adjustment of the control parameters is performed when the predicted RUL is below a threshold level, say 100 hours.

In an example, the control parameters may include supply voltage, armature voltage, armature resistance etc. in case of a DC motor and power supply frequency in case of an AC motor. More specifically, the control parameters are adjusted based on an application of the electric machine 105. For example, if the electric machine 105 is a motor used in a metal rolling operation, the speed may be reduced up to a certain level such that a quality of the worked metal is not reduced beyond a threshold level. For example, the quality may be indicated by accuracy with respect to a desired thickness of the worked metal. In an implementation, a list of options for a type of the application and a desired quality level may be provided on the user interface. The user may further choose the type of application and the desired quality level. Further, based on the user's selections, control parameters are identified from a lookup table stored in the database 195.

Further, the RUL is recalculated based on a known reliability analysis techniques. In a preferred embodiment, the RUL is estimated via simulations based on a Weibull cumulative damage model.

FIG 5 shows a Graphical User Interface 500 displaying an example of a current spectrum generated based on current signature of a motor. The current spectrum includes three spectral lines: a main component of 80 dB at 2792.4 Hz and two sidebands of 44 dB and 40 dB at (2792.4 - 59.4) Hz and (2792.4 + 59.4) Hz respectively. Misalignment at lower frequencies is detected based on the following equation:

$$\boldsymbol{f_e = f_1 + m f_r} \quad (5)$$

Here, $f_1$ is the supply frequency;

$f_r$ is the rotational speed frequency of the rotor;

m is the harmonic number (1, 2, 3..)

$f_e$ is the current component frequency due to airgap changes.

FIG 6 shows a workflow 600 for estimating RUL of a drive-end bearing of a motor, in accordance with an exemplary embodiment of the present invention.

At step 605, the virtual model is calibrated based on test data comprising current spectrum 610 for predefined misalignment values. More specifically, calibration is used to reduce deviations between misalignment values generated, at step 615, via simulation based on the virtual model and actual misalignment values in the test data. The virtual model is further updated based on operational data comprising vibration spectrum 620 of the motor, to reflect a real-time behaviour of the motor. The dotted lines between the blocks 610 and 620 indicate correlation between current spectrum and vibration spectrum that may be determined using regression algorithms as explained earlier with reference to FIG 3. At step 625, a simulation instance is generated based on the updated virtual model. The simulation instance is further executed in a simulation environment to generate simulation results indicative of one or more real-time misalignment values associated with the shaft 107 of the motor.

Advantageously, regression models correlating current spectrum to the vibration spectrum enhance detection of mechanical faults such as misalignment and eccentricity, that may be otherwise detected only using vibration signals.

At step 630, an dynamic misalignment force on the drive-end bearing is computed based on the misalignment value, using a predetermined misalignment force model. At step 635, the RUL is determined based on the computed dynamic misalignment force. At step 640, the RUL is further modified based on factors associated with contamination & lubrication associated with bearing. In addition to the above, the misalignment value is provided as an output on a user interface associated with a user. The user may further provide an input to the user interface for correcting the misalignment as shown at step 645. Further, steps 630 through 640 are repeated for a new misalignment value corresponding to the corrected misalignment. Here, the RUL is computed by the RUL model based on cumulative damage theory.

FIG 7 illustrates a workflow 700 for estimating RUL of a drive-end bearing of a motor, in accordance with another exemplary embodiment of the present invention.

At step 705, real-time operational data is obtained from at least one sensing unit associated with the motor. At step 710, at least one feature associated with the real-time operational data is used to configure a simulation instance of the virtual model of the coupled system. The simulation instance is further executed in a simulation environment to determine the misalignment value. At step 715, dynamic misalignment force resulting from the misalignment is determined using a predetermined misalignment force model. In parallel, at step 720, size of defects in the bearing resulting from contamination & lubrication associated with the bearing are determined. For example, a second virtual model is trained using a similar approach described in FIGS 3A and 3B, to compute size of defects resulting from contamination & lubrication factors.

The contamination factor is determined based on the defect size. This is because, defects in the bearing result in removal of small, discrete particles of material from the structure of the bearing. These discrete particles increase the concentration of contaminants inside the bearing. The concentration of contaminations further increases with increase in the defect size. The defect size is provided as input to a trained classification model that classifies the defect size into one of a plurality of severity levels. For example, the plurality of severity levels may correspond to 'normal cleanliness', 'slight to typical contamination', 'severe contamination' and 'very severe contamination'. Based on the defect size, the trained classification model outputs a severity level. The severity level thus determined is further used to select an appropriate contamination factor from a second lookup table stored in the database 195. The second lookup table may comprise values of contamination factor corresponding to each of the severity levels. It must be understood by a person skilled in the art that the classification model may be trained to classify the defect size into one of any number of severity levels.

The viscosity ratio is indicative of a lubrication condition of the bearing during operation. The viscosity ratio is calculated as the ratio of an operating viscosity of the lubricant to a rated viscosity of the lubricant. The operating viscosity is calculated based on a viscosity grade of the lubricant and an operating temperature. The viscosity grade of the oil may be obtained from a third look up table comprising viscosity grades corresponding to different types of lubricants. In one embodiment, the operating temperature of the bearing may be obtained from temperature sensors associated with the bearing. In another embodiment, the virtual model of the bearing may be used to determine a thermal profile of the bearing based on the operational data. The rated viscosity is obtained from a fourth look up table based on dimensions of the bearing and angular velocity of the bearing.

At step 725, the maximum impact force is computed using a predetermined impact force model, that correlates defect sizes in the bearing to the maximum impact force in the rating life model:

$$L_{10} = a_1 f\left(\frac{e_c C_u}{P}, K\right)\left(\frac{C}{P}\right)^3 \qquad (6)$$

Here, the dynamic equivalent radial load P is the same as a maximum impact force computed by the virtual model based on the real-time operational data, while other parameters are similar to that of equation (3). Similarly, RUL based on misalignment is estimated as explained earlier with reference to FIG 4 and 6. At step 730, a cumulative RUL is estimated from the RULs estimated from equations (3) and (6) based on cumulative damage theory. Further, a notification indicating the cumulative RUL may be further generated on an output device.

Advantageously, the present invention facilitates online estimation of effect of misalignment of the shaft, on a remaining useful life of a bearing supporting the shaft. Consequently, the downtime associated with taking the electric machine offline for manual inspection for misalignment is reduced. Further, a human operator may also take decisions on maintenance of the electric machine based on the remaining useful life provided via the output device.

The present invention is not limited to a particular computer system platform, processing unit, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of system, and is not limited to any particular distributed architecture, network, or communication protocol.

Reference Sign List

100 system for estimating RUL of a bearing
102 bearing
105 electric machine
107 shaft
110 apparatus for estimating RUL of a bearing
115 edge device
120 network
125 sensing unit
130 client device
135 processing unit
140 memory unit
145 storage unit
150 communication unit
155 network interface
160 standard interface or bus
165 bearing monitoring module
170 preprocessing module
175 analysis module
180 simulation module
185 life estimation module
190 notification module
195 database
200 ball bearing
210 outer race
215 plurality of balls 215
220 cage 220
225 inner race
305 motor
310 pump
315 coupling
320 driving shaft
325 driven shaft
330 casing
335 bearing
340 current transformers

345 vibration sensors
350 apparatus

## Claims

1. A computer-implemented method of estimating remaining useful life of a bearing (102) of an electric machine (105), the electric machine (105) operable to transfer rotational energy to a load via a shaft (107) supported by the bearing (102), the method comprising:

    obtaining operational data associated with the electric machine (105) and indicative of the misalignment of the shaft (107), in real-time from one or more sources (115, 125, 130);
    analysing the operational data to detect a misalignment of the shaft (107) of the electric machine (105);
    upon detecting the misalignment, using a virtual model of at least the electric machine (105) to simulate a real-time behaviour of at least the electric machine (105), to achieve a simulation result indicative of a misalignment value corresponding to the misalignment of the shaft (107);
    predicting a remaining useful life of the bearing (102) based on the misalignment value;
    generating a notification indicating the predicted remaining useful life of the bearing (102) on an output device.

2. The method according to claim 1, wherein analysing the operational data to detect the misalignment of the shaft (107) of the electric machine (105) comprises:

    computing a characteristic signature of the electric machine (105) based on the operational data;
    analysing the characteristic signature to detect misalignment of the shaft (107).

3. The method according to claim 2, wherein the characteristic signature is at least one of a current signature, a vibration signature and a thermal signature.

4. The method according to claim 2 or 3, wherein the characteristic signature is generated from the operational data using one or more transform functions.

5. The method according to claim 2, 3 or 4, wherein the characteristic signature is generated based on the operational data using a regression model.

6. The method according to any one of claims 1 to 5, wherein using the virtual model of at least the electric machine (105) to simulate the real-time behaviour of at least the electric machine (105), to achieve the simulation result indicative of the misalignment value corresponding to the misalignment of the shaft (107), comprises:

    dynamically updating the virtual model of at least the electric machine (105) based on the operational data upon detecting the misalignment;
    configuring a machine-executable simulation instance of at least the electric machine based on the updated virtual model; and
    executing the configured simulation instance in a simulation environment to generate the simulation result.

7. The method according to any one of the claims 1 to 6, wherein predicting the remaining useful life of the bearing (102) based on the misalignment value, comprises :

    computing a dynamic misalignment force on the bearing (102) in real-time based on the misalignment value using a predetermined misalignment force model;
    dynamically configuring a rating life model of the bearing (102) based on the computed dynamic misalignment force; and
    predicting the remaining useful life of the bearing (102) using the configured rating life model.

8. The method according to any one of claims 1 to 7, further comprising:
    using the predicted remaining useful life of the bearing (102) to adjust at least one control parameter of the electric machine (105).

9. The method according to claim 8, wherein the at least one control parameter is adjusted to modify at least one of a speed and load of the electric machine (105).

**10.** An apparatus (110) for estimating remaining useful life of a bearing (102) associated with an electric machine (105), the apparatus (110) comprising:

one or more processing units (135); and
a memory unit (140) operatively coupled to the one or more processing units (135), wherein the memory unit (140) comprises a bearing monitoring module (165) stored in the form of machine-readable instructions executable by the one or more processing units (135), wherein the bearing monitoring module (165) is configured to perform method steps according to any of the claims 1 to 9.

**11.** A system (100) for estimating remaining useful life of a bearing (102) associated with an electric machine (102), the system (100) comprising:

one or more sources (115, 125, 130) configured for providing operational data associated with the electric machine (105); and
an apparatus (110) according to claim 10, communicatively coupled to the one or more sources (115, 125, 130), wherein the apparatus (110) is configured for estimating remaining useful life of the bearing (102) based on the operational data, according to any of the method claims 1 to 9.

**12.** A computer-program having machine-readable instructions, which when executed by one or more computing devices, cause the one or more computing devices to perform a method according to any of the claims 1 to 9.

**13.** A machine-readable storage medium comprising a computer-program according to claim 12.

FIG 1A

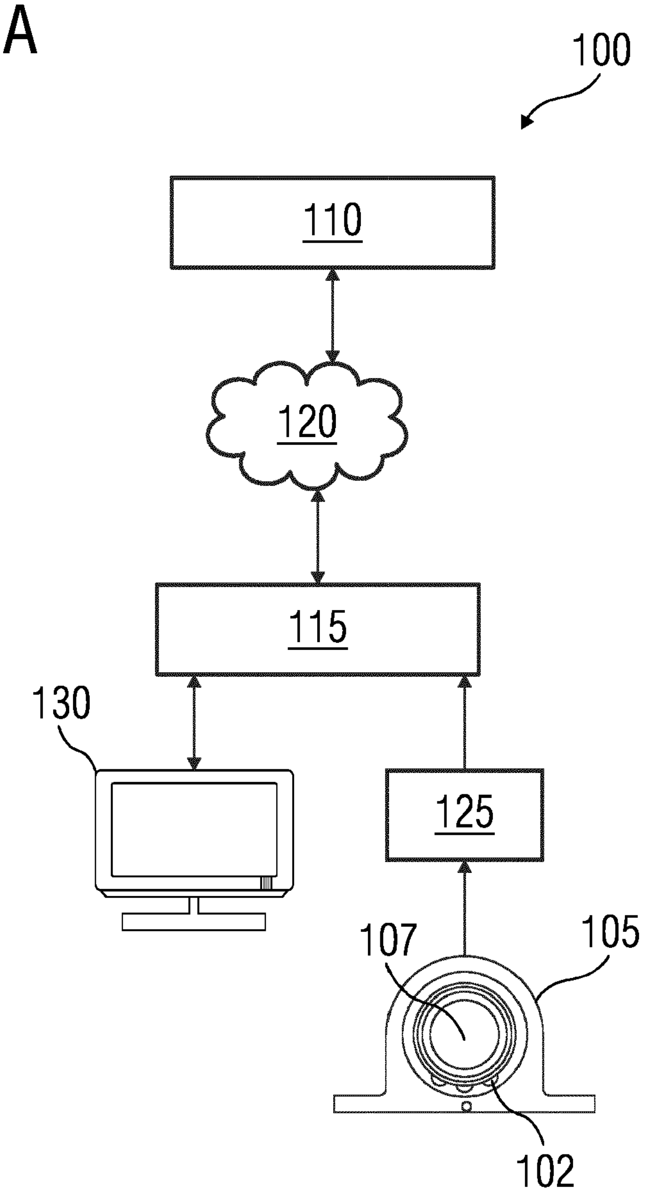

FIG 1B

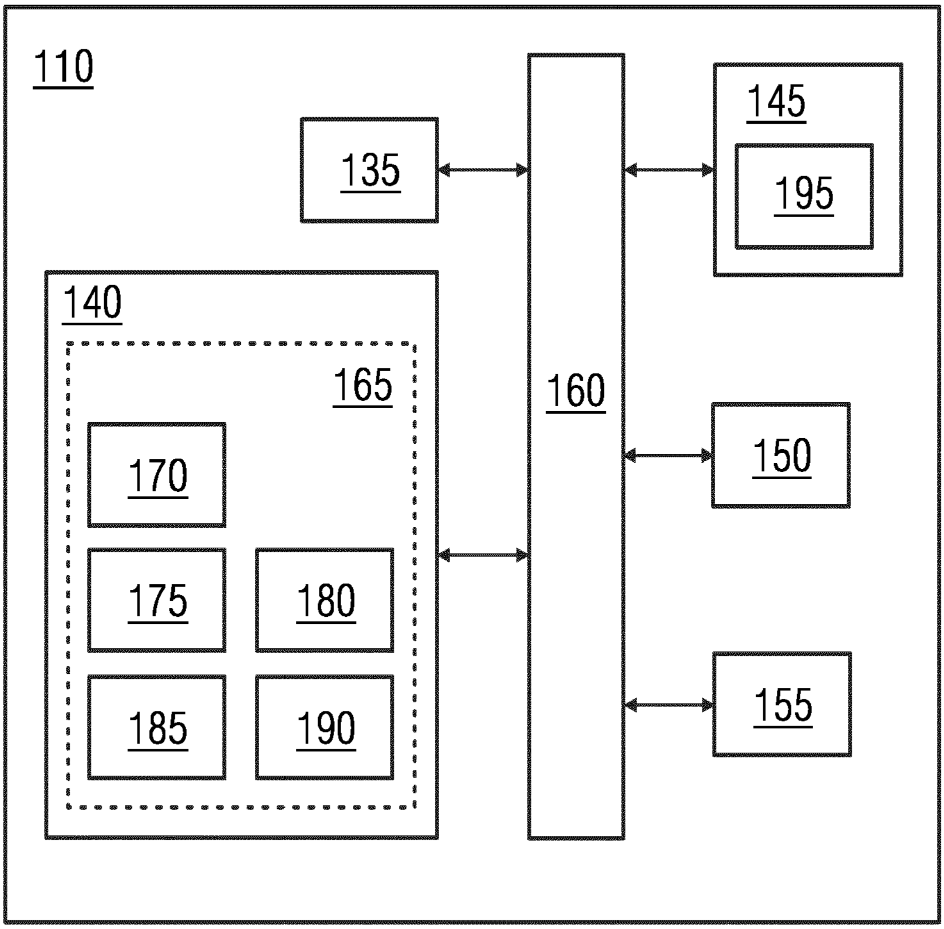

FIG 2

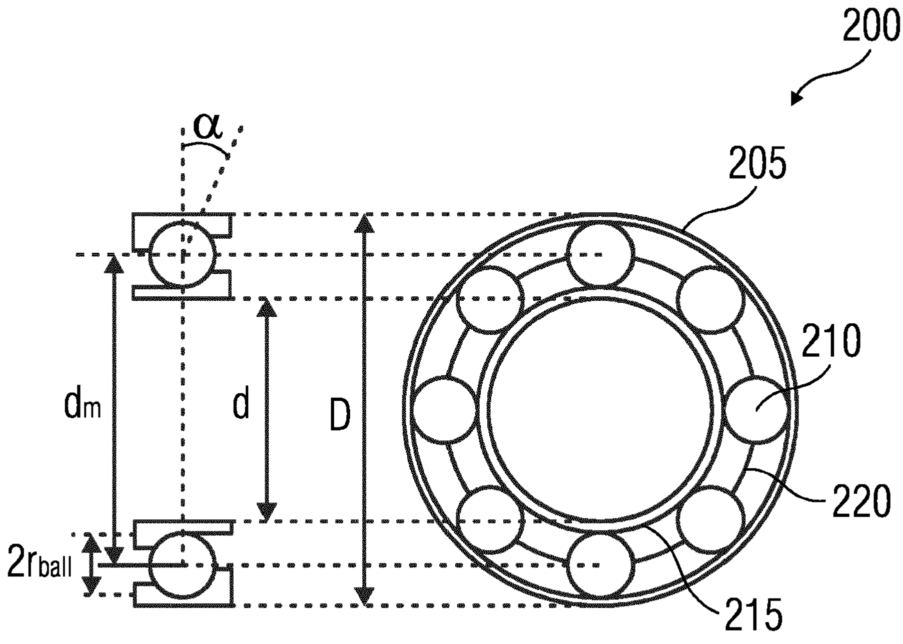

FIG 3A

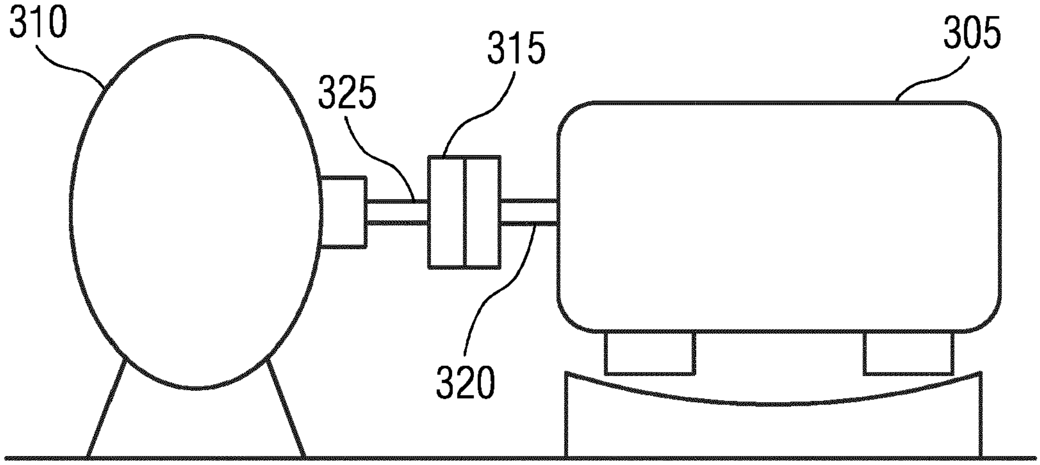

FIG 3B

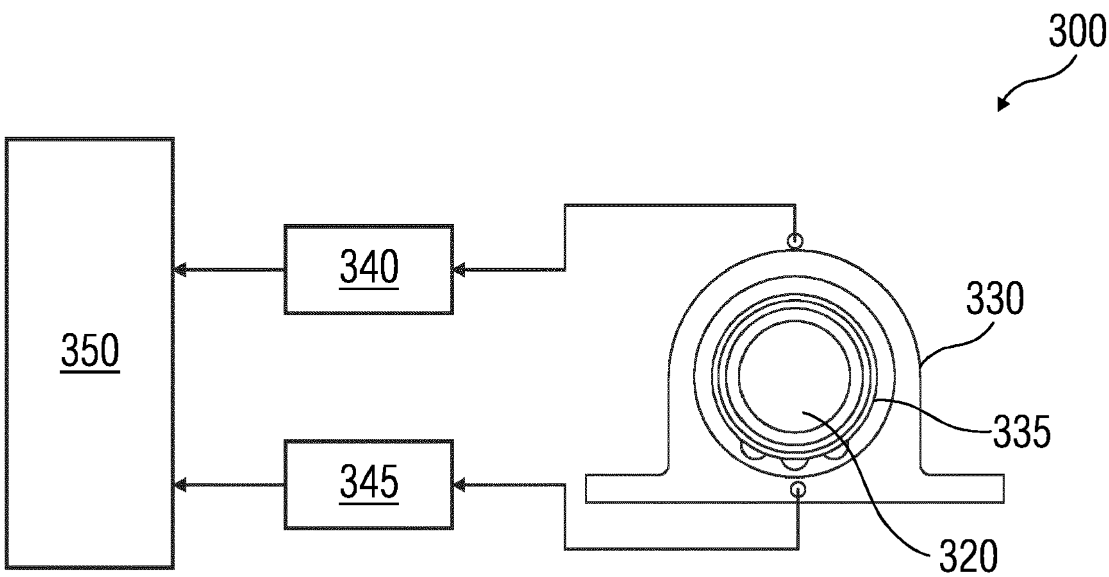

FIG 4

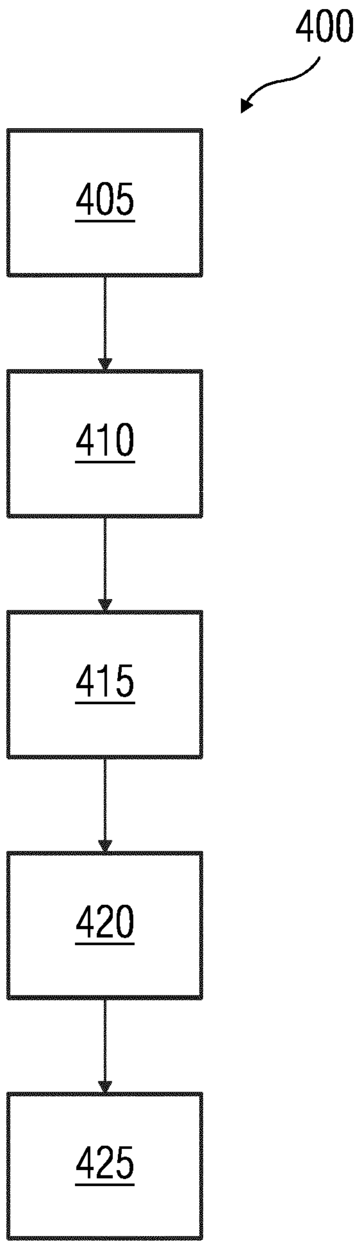

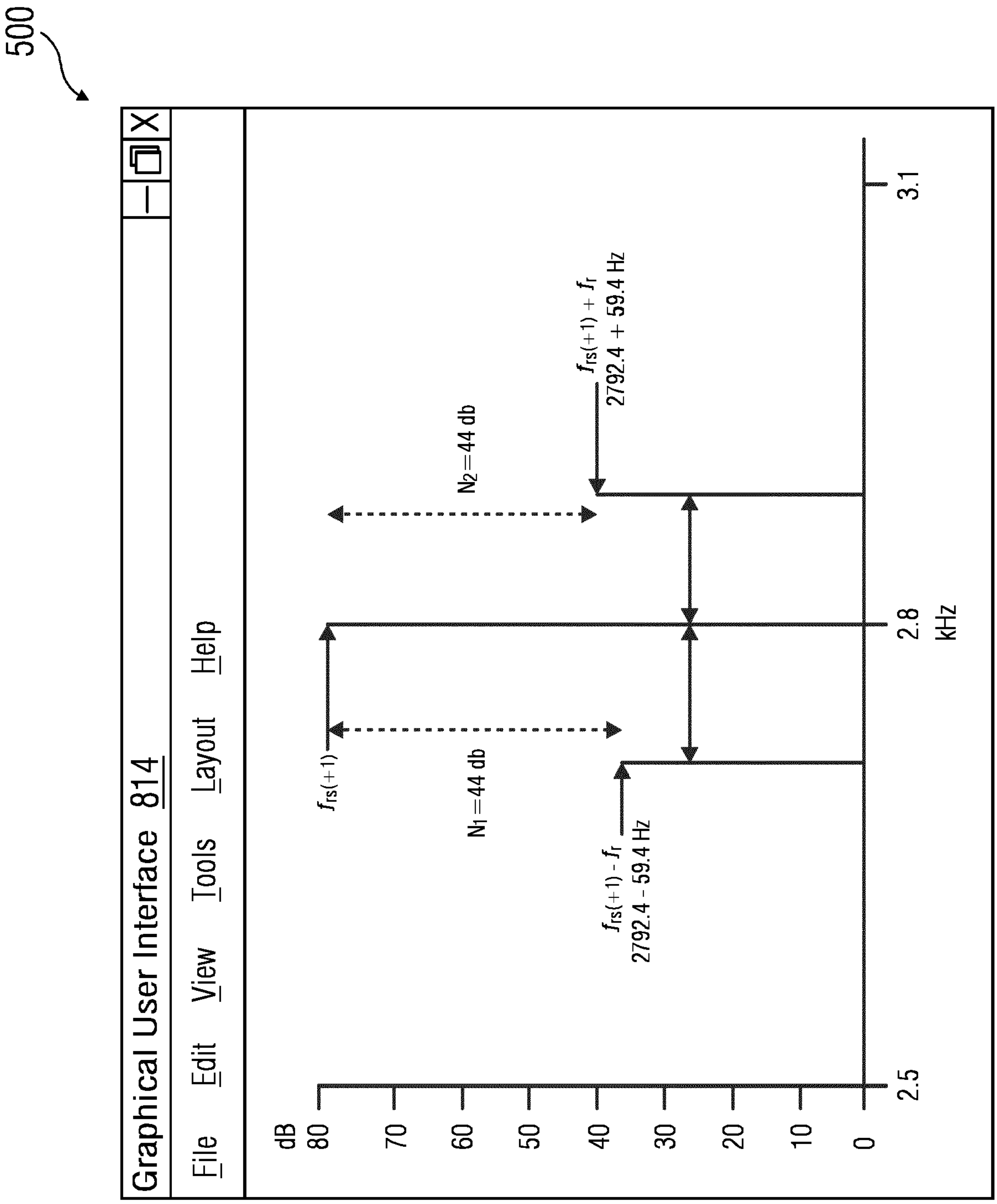
500
Graphical User Interface 814
File Edit View Tools Layout Help
dB
80
70
60
50
40
30
20
10
0
2.5
2.8
3.1
kHz
$f_{rs(+1)}$
N1=44 db
N2=44 db
$f_{rs(+1)} - f_r$
2792.4 - 59.4 Hz
$f_{rs(+1)} + f_r$
2792.4 + 59.4 Hz

FIG 5

FIG 6

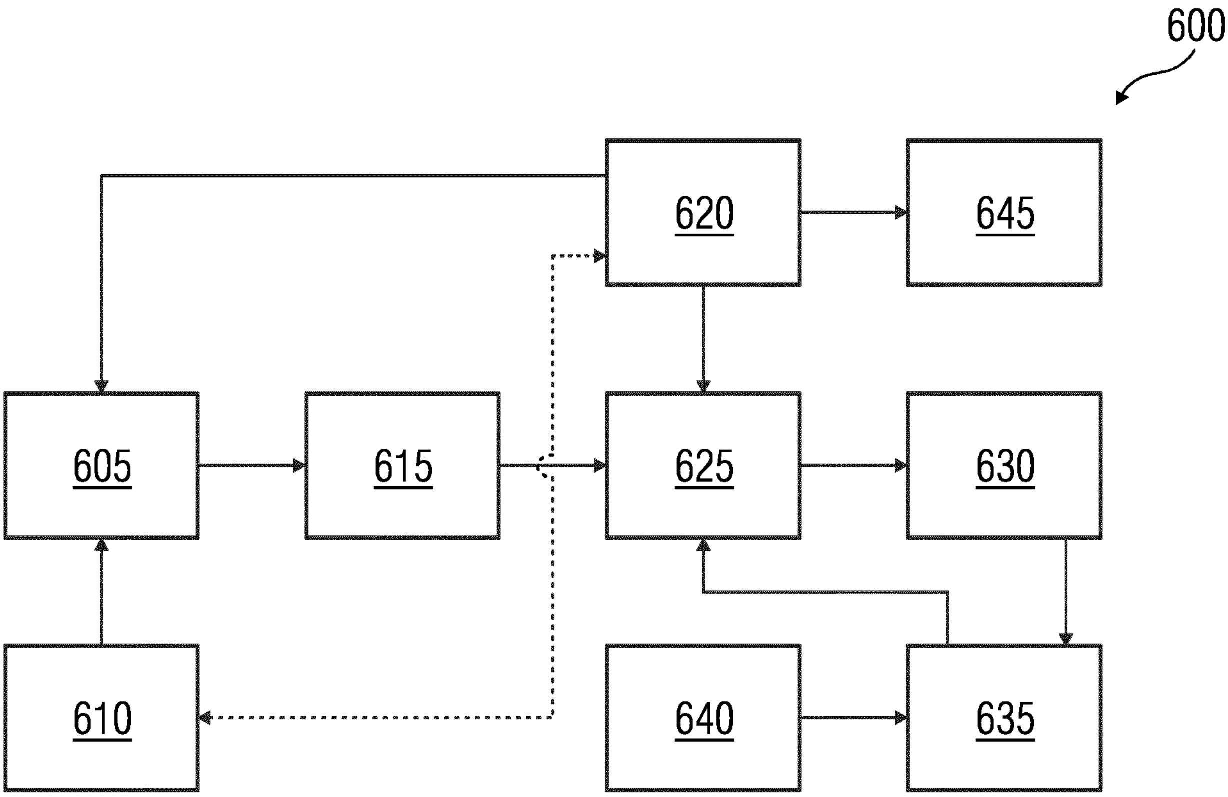

FIG 7

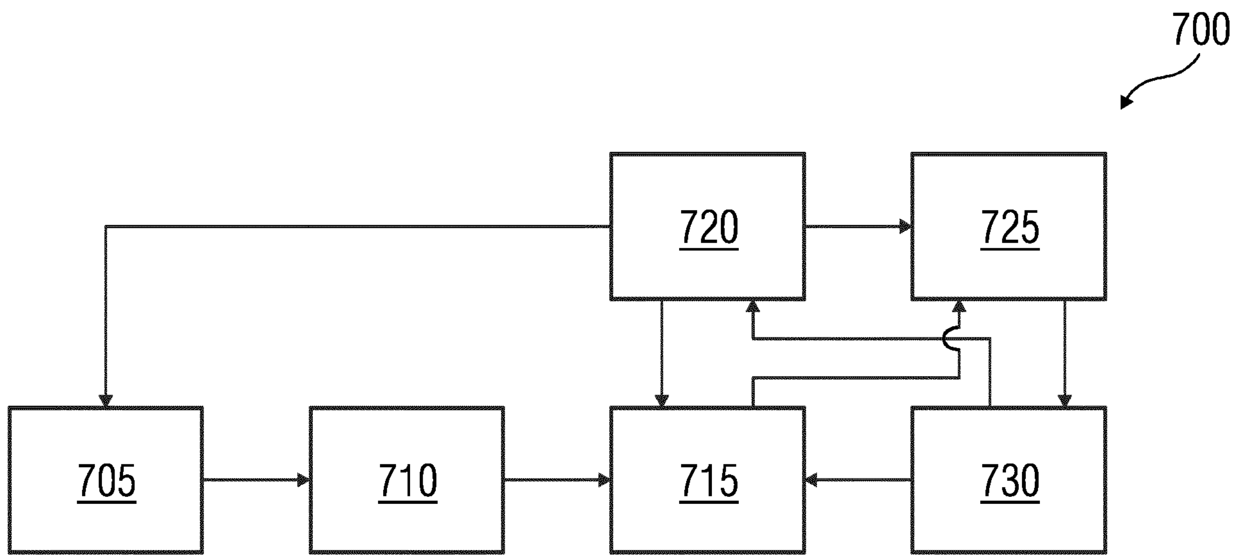

Europäisches Patentamt
European Patent Office
Office européen des brevets

# EUROPEAN SEARCH REPORT

Application Number
EP 22 16 5535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/256763 A1 (JÄPPINEN JARI [FI] ET AL) 13 August 2020 (2020-08-13)<br>* abstract *<br>* paragraphs [0025] - [0027] *<br>* figure 1 *<br>----- | 1-13 | INV.<br>G01M13/045 |
| A | CN 109 324 599 B (NEXTEV LTD)<br>2 April 2021 (2021-04-02)<br>* page 7, paragraph 4 *<br>----- | 5 | |

TECHNICAL FIELDS SEARCHED (IPC)

G01M

The present search report has been drawn up for all claims

2

| Place of search | Date of completion of the search | Examiner |
|---|---|---|
| The Hague | 9 September 2022 | Grewe, Clemens F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 16 5535

This annex lists the patent family members relating to the patent documents cited in the above-mentioned European search report. The members are as contained in the European Patent Office EDP file on
The European Patent Office is in no way liable for these particulars which are merely given for the purpose of information.

09-09-2022

| Patent document cited in search report | Publication date | Patent family member(s) | Publication date |
|---|---|---|---|
| US 2020256763 A1 | 13-08-2020 | CN 111448447 A | 24-07-2020 |
| | | EP 3704464 A1 | 09-09-2020 |
| | | US 2020256763 A1 | 13-08-2020 |
| | | WO 2019086123 A1 | 09-05-2019 |
| CN 109324599 B | 02-04-2021 | NONE | |

EPO FORM P0459

For more details about this annex : see Official Journal of the European Patent Office, No. 12/82